# EUROPEAN PATENT APPLICATION

(11) **EP 1 903 609 A2**
(43) Date of publication of application: **26.03.2008**
(21) Application number: 07018544.2
(22) Date of filing: 21.09.2007
(51) Int. Cl.: H01L 27/28, H01L 51/05

(54) **Method for manufacturing a thin film transistor array panel**

(30) Priority: 22.09.2006 KR 20060092228
(71) Applicant: Samsung Electronics Co., Ltd., Yeongtong-gu Suwon-city, Gyeonggi-do 442-742 (KR)
(72) Inventor: Yoon, Min-Ho, Gwanglin-gu, Seoul (KR); Kim, Young-Min, Suji-gu, Yongin-si, Gyeonggi-do (KR); Shin, Jung-Han, Giheung-gu,Yongin-si, Gyeonggi-do (KR); Oh, Joon-Hak, Yongin-si, Gyeonggi-do (KR); Choi, Tae-Young, Seongbuk-gu, Seoul (KR); Cho, Seung-Hwan, Hwaseong-si, Gyeonggi-do (KR)
(74) Representative: Dr. Weitzel & Partner

(57) **Abstract**

A method for manufacturing a thin film transistor ("TFT") array panel includes forming a gate electrode, forming source and drain electrodes insulated from the gate electrode, forming an organic semiconductor contacting the source and drain electrodes, spraying a solvent on the organic semiconductor, drying the solvent at room temperature, and annealing the organic semiconductor.

## Description

### BACKGROUND OF THE INVENTION

### (a) Field of the Invention

The present invention relates to organic thin turn transistor ("OTFT") array panels and a method for manufacturing such panels. More particularly, the present invention relates to a method of manufacturing OTFT array panels to improve characteristics thereof,

### (b) Description of the Related Art

Generally, a flat panel display such as a liquid crystal display ("LCD"), an organic light emitting diode ("OLED") display, and an electrophoretic display includes a pair of electric-field generating electrodes and an electro-optical active layer disposed therebetween. The LCD includes a liquid crystal layer as the electro-optical active layer, and the OLED display includes an organic light emitting layer as the electro-optical active layer.

One electrode within each pair of field generating electrodes is usually coupled with a switching element to receive electrical signals, and the electro-optical active layer converts the electrical signals into optical signals to display images.

The switching element for the flat panel display includes a thin film transistor ("TPT") having three terminals, and gate lines transmitting control signals for controlling the TFTs and data lines transmitting data signals to be supplied to the pixel electrodes through the TFTs are also provided in the flat panel display.

Among the TFTs, organic TFTs ("OTFTs") are being vigorously developed. An OTFT includes an organic semiconductor instead of an inorganic semiconductor such as silicon Si.

Because the OTFT may be manufactured by a solution process at a low temperature, it may be easily adapted to a flat panel display with a large size, which may not be manufactured by a deposition process. Also, because the organic material has a characteristic such that the organic material is made of patterns such as a fiber or a film, the OTFT is used as the core element of a flexible display device.

However, the characteristics of the OTFT such as on-current Ion / off-current Ioff may be deteriorated in comparison with the TFT using an inorganic semiconductor material.

### BRIEF SUMMARY OF THE INVENTION

The present invention provides a method for manufacturing a thin film transistor ("TFT") array panel for improving the characteristics of an organic TFT ("OTFT").

According to exemplary embodiments of the present invention, an exemplary method for manufacturing an exemplary TFT array panel includes forming a gate electrode, forming source and drain electrodes insulated from the gate electrode, forming an organic semiconductor contacting the source and drain electrodes, spraying a solvent on the organic semiconductor, drying the solvent at room temperature, and annealing the organic semiconductor.

The solvent may include at least one of tetralin, cyclohexane, benzene, xylene, anisole, benzonitrile, lutidine, morpholine, aniline, toluene, pyridine, dioxane, and derivatives thereof. The organic semiconductor may be formed by a solution process using an organic semiconductor solution including a high molecular organic material and a solvent, and the solution process may be ink-jet printing. The solvent used in spraying a solvent on the organic semiconductor may be the same as the solvent within the organic semiconductor solution.

The annealing process may be executed at a temperature of about 70 to 130 degrees Celsius.

The method may further include forming a partition defining an opening for the organic semiconductor before forming the organic semiconductor. The method may further include forming a gate insulator after forming the gate electrode and before forming the source and drain electrodes, wherein the gate insulator is formed by ink-jet printing.

Other exemplary embodiments of an exemplary method of manufacturing an exemplary TFT array panel include forming a gate electrode, forming source and drain electrodes insulated from the gate electrode, and forming an organic semiconductor contacting the source and drain electrodes, wherein forming the organic semiconductor includes spraying an organic semiconductor solution, first-drying the organic semiconductor solution, re-melting the organic semiconductor solution to form re-melted organic semiconductor solution, and second-drying the re-melted organic semiconductor solution.

A solvent may be sprayed on the organic semiconductor solution for re-melting. The solvent may include at least one of tetralin, cyclohexane, benzene, xylene, anisole, benzonitrile, lutidine, morpholine, aniline, toluene, pyridine, dioxane, and derivatives thereof, The solvent of the spraying may be the same as the solvent of the organic semiconductor solution.

Second-drying the re-melted organic semiconductor solution may include drying at room temperature and annealing the organic semiconductor solution, where annealing may be executed at a temperature of about 70 to 130 degrees Celsius.

According to still other exemplary embodiments of the present invention, an exemplary method of improving characteristics of an exemplary TFT having an organic semiconductor includes providing an organic semiconductor solution including an organic material and a first solvent for the TFT, first-drying the organic semiconductor solution to form an organic semiconductor having a first arrangement of organic semiconductor molecules, melting and second-drying the organic semiconductor to form an organic semiconductor having a second arrangement of organic semiconductor molecules different than the first arrangement of organic semiconductor molecules and to provide the TFT with characteristics different than characteristics of a TFT having an organic semiconductor with the first arrangement of organic semiconductor molecules.

For example, a ratio of on-current to off-current of the TFT having the second arrangement of organic semiconductor molecules may be greater than a ratio of on-current to off-current of a TFT having the first arrangement of organic semiconductor molecules.

Melting the organic semiconductor to form an organic semiconductor having a second arrangement of organic semiconductor molecules may include applying a second solvent The second solvent may be the same solvent as the first solvent. Applying the second solvent may include spraying the second solvent with an ink-jet nozzle.

Second-drying the organic semiconductor to form an organic semiconductor having a second arrangement of organic semiconductor molecules may include drying at room temperature and performing an annealing process.

### BRIEF DESCRIPTION OF THE DRAWINGS

The present invention will become more apparent by describing exemplary embodiments thereof in detail with reference to the accompanying drawings, in which:
Fig. 1 is a layout view of an exemplary thin film transistor ("TFT") array panel according to an exemplary embodiment of the present invention;
Fig. 2 is a sectional view of the exemplary TFT array panel shown in Fig. 1 taken along line II-II,
Figs. 3, 5, 7, 9, and 11 are layout views of the exemplary organic TFT array panel shown in Figs. 1 and 2 during intermediate steps of an exemplary manufacturing method thereof according to an exemplary embodiment of the present invention;
Fig. 4 is a sectional view of the exemplary TFT array panel shown in Fig. 3 taken along line IV-IV;
Fig. 6 is a sectional view of the exemplary TFT array panel shown in Fig. 5 taken along line VI-VI;
Fig. 8 is a sectional view of the exemplary TFT array panel shown in Fig. 7 taken along line VIII-VIII;
Fig. 10 is a sectional view of the exemplary TFT array panel shown in Fig. 9 taken along line X-X;
Fig. 12 is a sectional view of the exemplary TFT array panel shown in Fig. 11 taken along line XII-XII;
Figs. 13 to 15 are sectional views of the exemplary TFT array panel showing the following steps of Figs. 11 and 12;
Fig. 16A is a graph showing the current characteristics of an exemplary OTFT before re-melting an exemplary organic semiconductor; and
Fig. 16B is a graph showing the current characteristics of an exemplary OTFT after re-melting an exemplary organic semiconductor.

### DETAILED DESCRIPTION OF THE INVENTION

The present invention is described in detail herein with reference to the accompanying drawings, in which preferred embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. Like numerals refer to like elements throughout.

In the drawings, the thickness of layers and regions are exaggerated for clarity. Like numerals refer to like elements throughout. When an element such as a layer, region, or substrate is referred to as being "on" another element, it can be directly on the other element or intervening elements may also be present In contrast, when an element is referred to as being directly on another element, there are no intervening elements present. As used herein, the term "and/or" includes any and all combinations of one or more of the associated listed items.

It will be understood that, although the terms first, second, third etc, may be used herein to describe various elements, components, regions, layers and/or sections, these elements, components, regions, layers and/or sections should not be limited by these terms. These terms are only used to distinguish one element, component region, layer or section from another element, component, region, layer or section. Thus, a first element, component, region, layer or section discussed below could be termed a second element, component, region, layer or section without departing from the teachings of the present invention.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Spatially relative terms, such as "beneath", "below", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments of the present invention are described herein with reference to cross section illustrations that are schematic illustrations of idealized embodiments of the present invention. As such, variations from the shapes of the illustrations as a result, for example, of manufacturing techniques and/or tolerances, are to be expected. Thus, embodiments of the present invention should not be construed as limited to the particular shapes of regions illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present invention.

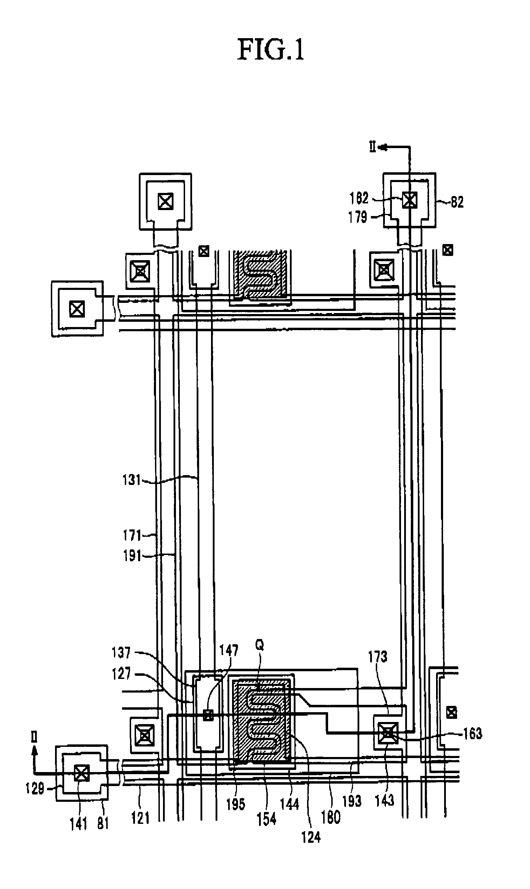

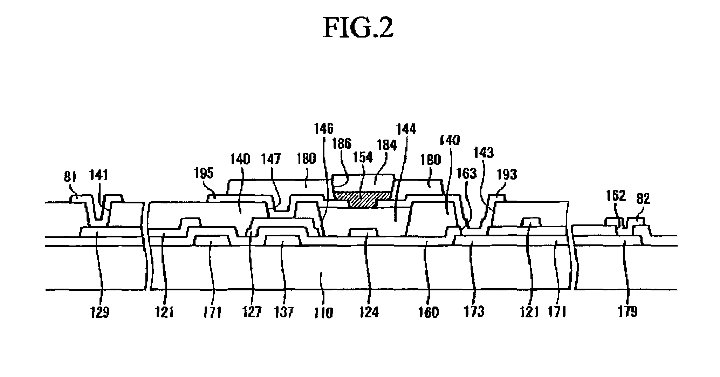

An organic thin film transistor ("OTFT") array panel according to an exemplary embodiment of the present invention will be described in detail with reference to Figs. 1 and 2.

Fig. 1 is a layout view of an exemplary OTFT array panel according to an exemplary embodiment of the present invention, and Fig. 2 is a sectional view of the exemplary OTFT array panel shown in Fig,1 taken along line II-II.

A plurality of data lines 171 and a plurality of storage electrode lines 131 are formed on an insulating substrate 110 made of a material such as transparent glass, silicone, or plastic.

The data lines 171 transmit data signals and extend substantially in a longitudinal direction, a first direction. Each data line 171 includes a plurality of projections 173 protruded aside towards an adjacent data line 171, and an end portion 179 having a large area for contact with another layer or an external driving circuit. A data driving circuit (not shown) for generating the data signals may be mounted on a flexible printed circuit ("FPC") film (not shown), which may be attached to the substrate 110, directly mounted on the substrate 110, or integrated with the substrate 110. The data lines 171 may extend to connect to a driving circuit that may be integrated with the substrate 110.

The storage electrode lines 131 transmit a predetermined voltage such as a common voltage and extend in the longitudinal direction, the first direction, substantially parallel to the data lines 171. Each storage electrode line 131 is disposed between two adjacent data lines 171 and doser to a left one of the two adjacent data lines 171, and includes a plurality of storage electrodes 137 extended aside, such as towards both adjacent data lines 171. While a particular shape and arrangement is illustrated and described; the storage electrode lines 131 may have various shapes and arrangements within the scope of these embodiments.

The data lines 171 and storage electrode lines 131 are preferably made of a metal including aluminum A1 or an AI alloy, silver Ag or an Ag alloy, gold Au or an Au alloy, copper Cu or a Cu alloy, molybdenum Mo or a Mo alloy, chromium Cr, tantalum Ta, or titanium Ti. The conductors may have a multi-layered structure including two conductive films (not shown) having different physical characteristics.

The lateral sides of the data lines 171 and the storage electrode lines 131 are inclined relative to a surface of the substrate 110, and the inclination angle thereof ranges from about 30 to about 80 degrees.

A lower interlayer insulating layer 160 is formed on the data lines 171 and storage electrode lines 131, as well as on exposed surfaces of the substrate 110. The lower interlayer insulating layer 160 may be made of an inorganic insulator such as silicon nitride (SiNx) and silicon oxide (SiOx), or an organic insulating material. It is preferable that the thickness of the lower interlayer insulating layer 160 is in the range of about 2000 to about 5000 angstroms.

The lower interlayer insulating layer 160 has a plurality of contact holes 162 exposing the end portions 179 of the data lines 171, and a plurality of contact holes 163 exposing the projections 173 of the data lines 171.

A plurality of gate lines 121 and a plurality of storage capacitor conductors 127 are formed on the lower interlayer insulating layer 160.

The gate lines 121 transmit gate signals and extend substantially in a transverse direction, a second direction that is substantially perpendicular to the first direction. Each of the gate lines 121 intersects the data lines 171 and the storage electrode lines 131 and includes a plurality of gate electrodes 124 projecting upward towards an adjacent gate line 121, and an end portion 129 having a large area for contact with another layer or an external driving circuit. A gate driving circuit (not shown) for generating the gate signals may be mounted on an FPC film (not shown), which may be attached to the substrate 110, directly mounted on the substrate 110, or integrated with the substrate 110. The gate lines 121 may extend to connect to a driving circuit that may be integrated with the substrate 110.

The storage capacitor conductors 127 are separated from the gate lines 121 and overlap the storage electrodes 137.

The gate lines 121 and the storage capacitor conductors 127 may be made of the same conductor material having low resistivity as that of the data lines 171 and the storage electrode lines 131.

The lateral sides of the gate lines 121 and the storage capacitor conductors 127 are inclined relative to a surface of the substrate 110, and their inclination angles range from about 30 to about 80 degrees.

An upper interlayer insulating layer 140 is formed on the gate lines 121 and the storage capacitor conductors 127, and may be further formed on the exposed portions of the lower interlayer insulating layer 160. The upper interlayer insulating layer 140 may be made of an organic photosensitive material that may be formed by a solution process. It is preferable that the thickness of the upper interlayer insulating layer 140 is in the range of about 5000 angstroms to about 4 microns.

The portion of the upper interlayer insulating layer 140 neighboring the end portion 179 is removed to prevent poor adhesion between the upper interlayer insulating layer 140 and the lower interlayer insulating layer 160 and to effectively connect the end portion 179 of the data line 171 to the external circuit by reducing the total thickness of the interlayer insulating layer.

The upper interlayer insulating layer 140 has a plurality of openings 146 exposing the gate electrodes 124, a plurality of contact holes 141 exposing the end portions 129 of the gate lines 121, a plurality of contact holes 143 exposing the projections 173 of the data line 171 through the contact holes 163, and a plurality of contact holes 147 exposing the storage capacitor conductors 127. Each opening 146 may further expose a portion of the lower interlayer insulating layer 160 surrounding the respective gate electrode 124.

A plurality of gate insulators 144 are formed in the openings 146 of the upper interlayer insulating layer 140. The gate insulators 144 are preferably made of, or from derivatives of, polyacryl, polystyrene, polyimide, polyvinyl alcohol parylene, perfluorocyclobutane, perfluorovinylether, or benzocyclobutane (BCB). The gate insulators 144 cover the gate electrodes 124 and may further cover a portion of the lower interlayer insulating layer 160 surrounding the respective gate electrode 124 and exposed by the opening 146, and the thickness of the gate insulators 144 is in the range of about 1000 to 10,000 angstroms. Because the side wall of the openings 146 is higher than the thickness of the gate insulators 144, the upper interlayer insulating layer 140 is banked, and it is preferable that the openings 146 have sufficient size for the gate insulators 144 to have flat surfaces.

A plurality of source electrodes 193, a plurality of pixel electrodes 191, and a plurality of contact assistants 81 and 82 are formed on the upper interlayer insulating layer 140, They are preferably made of indium tin oxide ("ITO") or indium zinc oxide ("IZO"), and may have thickness in the range of about 200 to 2000 angstroms,

The source electrodes 193 are electrically connected to the projections 173 of the data lines 171 through the contact holes 143 and 163, and are extended to the upper portion of the gate electrodes 124 by overlapping the gate insulators 144 thereon.

Each pixel electrode 191 includes a portion 195 disposed opposite a source electrode 193 with respect to a gate electrode 124 by overlapping the gate insulator 144 thereon. This portion 195 of the pixel electrode 191 is hereinafter referred to as the drain electrode 195, and is connected to the storage capacitor conductors 127 through the contact holes 147.

The pixel electrodes 191 overlap the gate lines 121 and the data lines 171 to increase the aperture ratio.

The drain electrodes 195 and the source electrodes 193 may have serpentine edges that face each other. The edges may be separated from each other by a distance that remains substantially constant for each pair of drain-source electrodes 195,193.

The contact assistants 81 and 82 are connected to the end portions 129 and 179 of the data lines 171 and the gate lines 121 through the contact holes 141 and 162. The contact assistants 81 and 82 protect the end portions 129 and 179 and enhance the adhesion between the end portions 129 and 179 and external devices.

A plurality of partitions 180 are formed on the source electrodes 193, the pixel electrodes 191, and may be further formed on the upper interlayer insulating layer 140. The partitions 180 have a plurality of openings 186 disposed on the gate electrode 124 and the openings 146 of the upper interlayer insulating layer 140 for exposing portions of the source electrodes 193 and the drain electrodes 195, and the portions of the gate insulators 144 therebetween.

The partitions 180 are preferably made of a photosensitive organic material that may be formed by a solvent process, and has a thickness of about 5000 angstroms to 4 microns. The openings 186 are smaller than the openings 146 of the upper interlayer insulating layer 140 such that the partitions 180 are solidly fixed to the gate insulators 144 to prevent them from lifting, and penetration of the chemical solvent may be prevented in the manufacturing process.

A plurality of organic semiconductor islands 154 are placed in the openings 186 of the partitions 180. The organic semiconductor islands 154 are disposed on the gate electrodes 124, with the gate insulators 144 there between, and the organic semiconductor islands 154 contact the source electrodes 193 and the drain electrodes 195. Because the height of the organic semiconductor islands 154 is smaller than that of the partitions 180, the organic semiconductor islands 154 are completely enclosed by the partitions 180,

The organic semiconductor islands 154 may include a high molecular compound or a low molecular compound, which is soluble in an aqueous solution or organic solvent In this case, the organic semiconductor islands 154 can be formed by (inkjet) printing.

The organic semiconductor islands 154 may be made of, or from derivatives of, polyphenlenevinylene, polyfluorene, polythienylenevinylene, polythiophene, pvlythienothiophene, or polyarylamine.

The organic semiconductor islands 154 may be made of poly 3-hexylthiophene, perylene tetracarboxylic dianydride ("PTCDA"), naphthalene tetracarboxylic dianhydride ("NTCDA"), or their imide derivatives. The organic semiconductor islands 154 may also be made of perylene, coronene, or derivatives thereof with a substituent.

A plurality of passivation members 184 are formed on the organic semiconductor islands 154 in the openings 186 of the partitions 180. The passivation members 184 protect the organic semiconductor islands 154 from being damaged by external heat, plasma, or chemical materials in the manufacturing process.

A gate electrode 124, a source electrode 193, a drain electrode 195, and an organic semiconductor island 154 form an OTFT Q. The OTFT Q has a channel formed in the organic semiconductor island 154 disposed between the source electrode 193 and the drain electrode 195.

The pixel electrodes 191 receive data voltages from the OTFT Q and generate an electric field in conjunction with a common electrode (not shown) of an opposing display panel (not shown) supplied with a common voltage, which determines the orientations of liquid crystal molecules (not shown) in a liquid crystal layer (not shown) disposed between the common electrode and the pixel electrodes 191. A pixel electrode 191 and the common electrode form a capacitor referred to as a "liquid crystal capacitor," which stores applied voltages even after the organic TFT turns off.

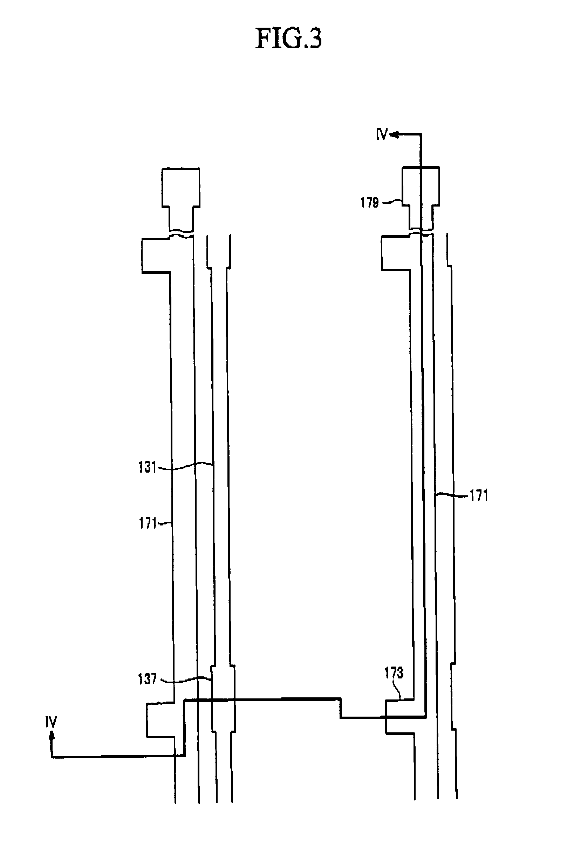

Now, an exemplary method of manufacturing the exemplary OTFT array panel shown in Figs. 1 and 2 according to an exemplary embodiment of the present invention will be described in detail with reference to Figs. 3 to 15 and with further reference to Figs. 1 and 2.

Figs. 3, 5, 7, 9, and 11 are layout views of the exemplary OTFT array panel shown in Figs. 1 and 2 during intermediate steps of an exemplary manufacturing method thereof according to an exemplary embodiment of the present invention.

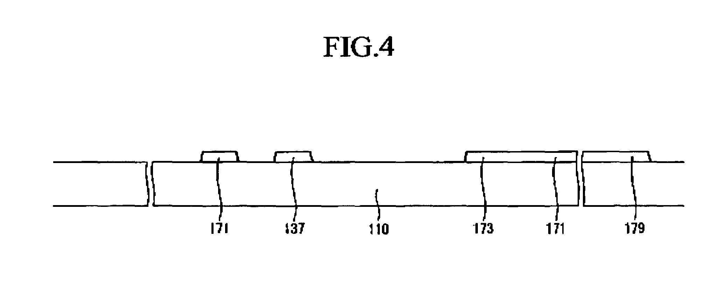

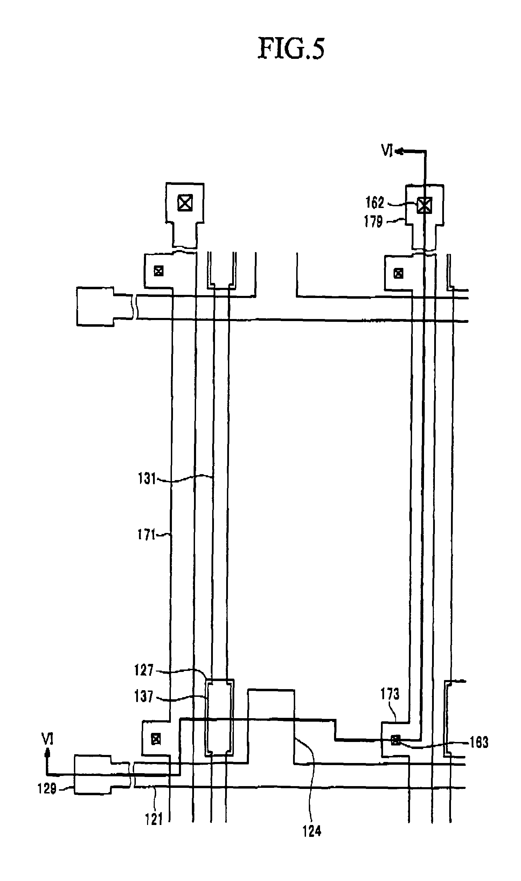

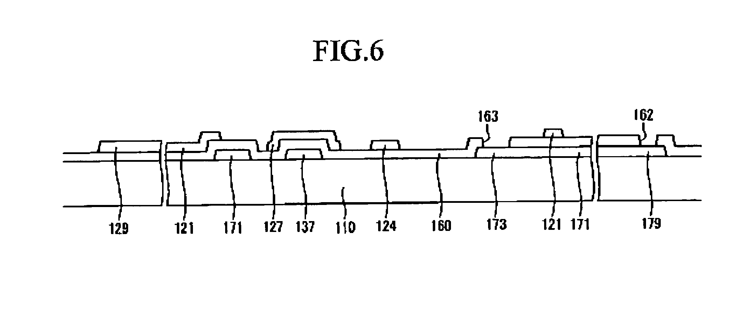

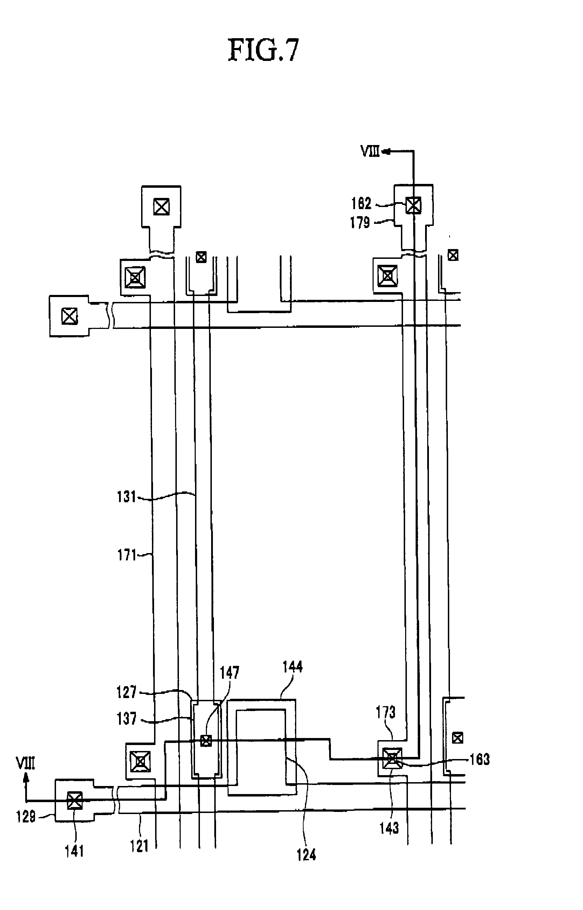

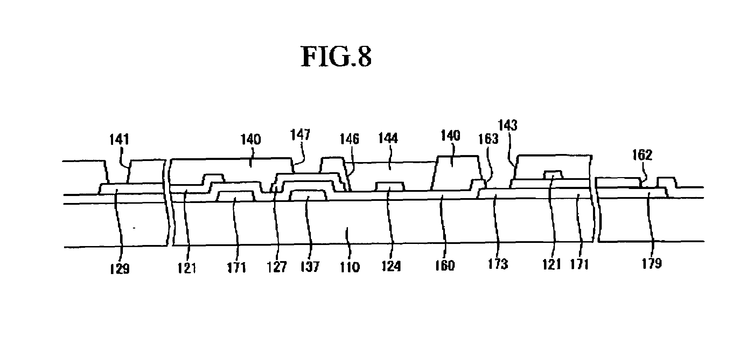

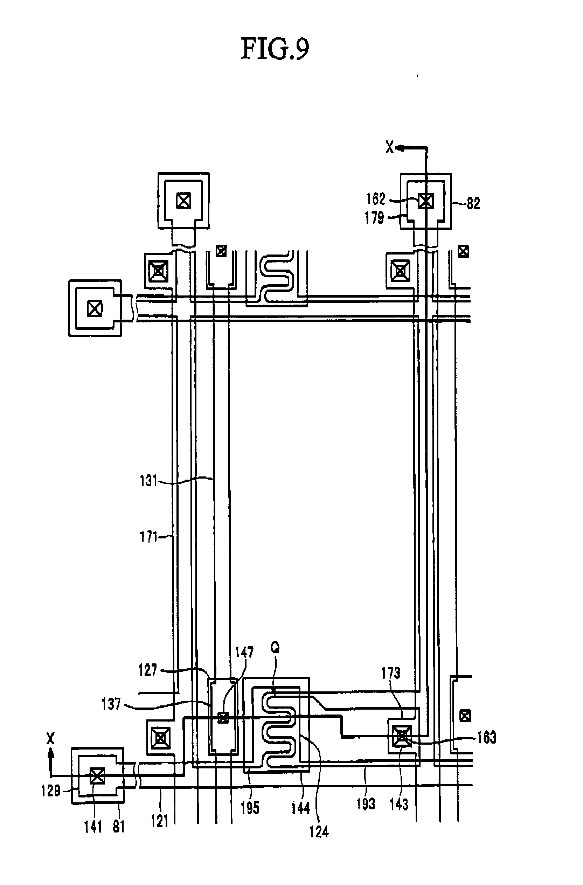

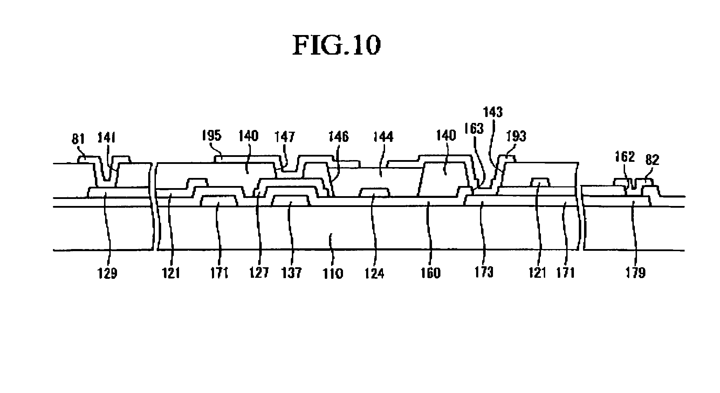

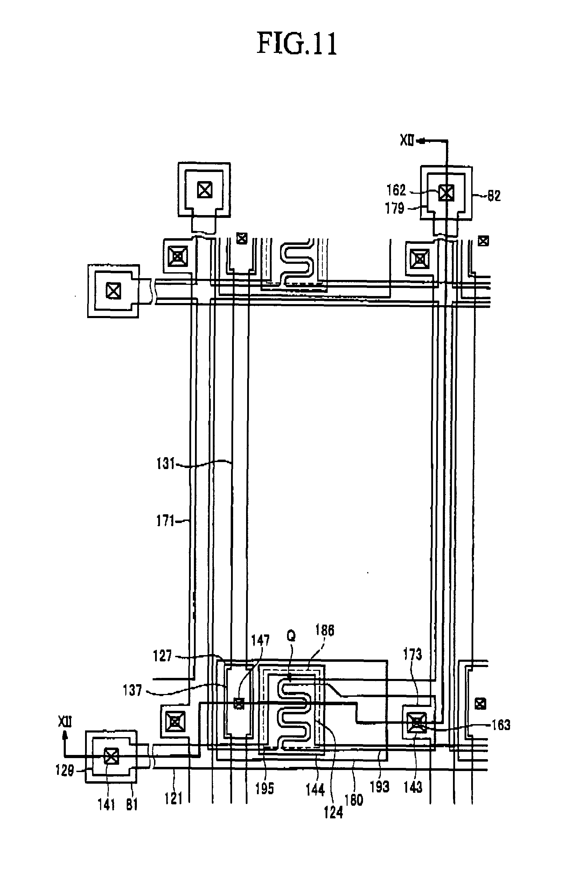

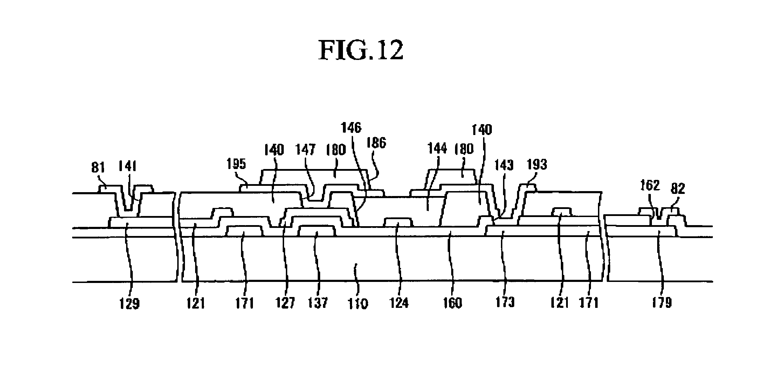

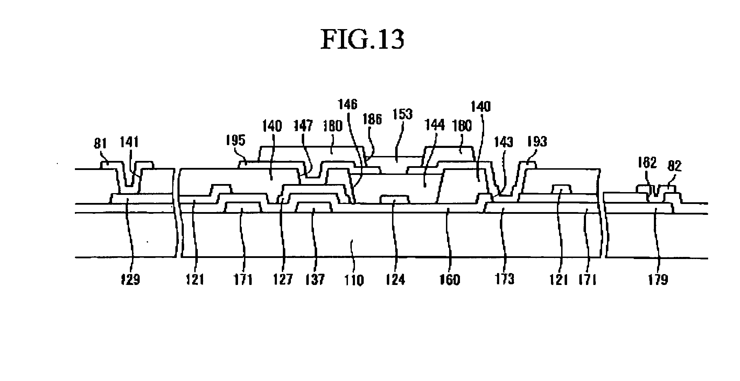

Fig. 4 is a sectional view of the exemplary TFT array panel shown in Fig. 3 taken along line IV-IV, Fig. 6 is a sectional view of the exemplary TFT array panel shown in Fig. 5 taken along line VI-VI, Fig. 8 is a sectional view of the exemplary TFT array panel shown in Fig. 7 taken along line VIII-VIII, Fig. 10 is a sectional view of the exemplary TFT array panel shown in Fig. 9 taken along line X-X, Fig. 12 is a sectional view of the exemplary TFT array panel shown in Fig. 11 taken along line XII-XII, and Figs. 13 to 15 are sectional views of the exemplary TFT array panel showing the following steps of Figs. 11 and 12.

Referring to Figs. 3 and 4, a conductive layer is deposited on a substrate 110 by using sputtering, etc., and is patterned by lithography and etched to form a plurality of data lines 171 including projections 173 and end portions 179, and a plurality of storage electrode lines 131 including a plurality of storage electrodes 137.

Referring to Figs. 5 and 6, a lower interlayer insulating layer 160 having a plurality of contact holes 163 and 162 is deposited on the data lines 171, the storage electrode lines 131, and the exposed portions of the substrate 110. The lower interlayer insulating layer 160 may be made of an inorganic material it may be deposited by chemical vapor deposition ("CVD"), etc., and it may be made of an organic material and deposited by spin coating, for example.

Next, a conductive layer is deposited on the lower interlayer insulating layer 160 and the substrate 110 by using sputtering, etc., and is patterned by lithography and etched to form a plurality of gate lines 121 including the gate electrodes 124 and end portions 129 and a plurality of storage capacitor conductors 127.

Referring to Figs. 7 and 8, a photosensitive organic material is spin coated and patterned to form an upper interlayer insulating layer 140 having a plurality of openings 146 and a plurality of contact holes 143, 141, and 147. The portion of the upper interlayer insulating layer 140 neighboring the end portion 179 of each data line 121 is removed.

Next, a plurality of gate insulators 144 are formed in the openings 146 of the upper interlayer insulating layer 140 by inkjet printing an organic insulating solvent in the openings 146 on the gate electrodes 124 and thermal treatment

Referring to Figs. 9 and 10, an amorphous ITO layer or IZO layer is deposited on the upper interlayer insulating layer 140, portions of the gate insulator 144, and on the lower interlayer insulating layer 160 in the vicinity of the end portions 179. The amorphous ITO layer or IZO layer is then patterned by lithography and wet etched with an etchant to form a plurality of source electrodes 193, a plurality of pixel electrodes 191 including drain electrodes 195, and a plurality of contact assistants 81 and 82.

The deposition of the amorphous ITO layer and IZO layer may be performed at a low temperature of about 25 to 100°C, and preferably at room temperature. The etchant for the amorphous ITO layer and IZO layer may include a weak alkaline etchant to reduce damage to the gate insulators 144 and the upper interlayer insulating layer 140 that are made of an organic material, by heat or a chemical solvent

Referring to Figs. 11 and 12, a photosensitive organic material is coated and developed to form a plurality of partitions 180 including a plurality of openings 186 exposing the gate insulators 144 between the source electrodes 193 and the drain electrodes 195.

Referring to Fig. 13, an organic semiconductor solution is dripped in the openings 186 to form a plurality of semiconductor islands 153. The organic semiconductor solution may be made of the organic material, previously described with reference to the organic semiconductor islands 154 with reference to the description corresponding to Figs. 1 and 2, and a solvent. The solvent is preferably made of, or from derivatives of, tetralin, cyclohexane, benzene, xylene, anisole, benzonitrile, lutidine, morpholine, aniline, toluene, pyridine, and dioxane.

Next, the organic semiconductor solution is dried to form the semiconductor islands 153.

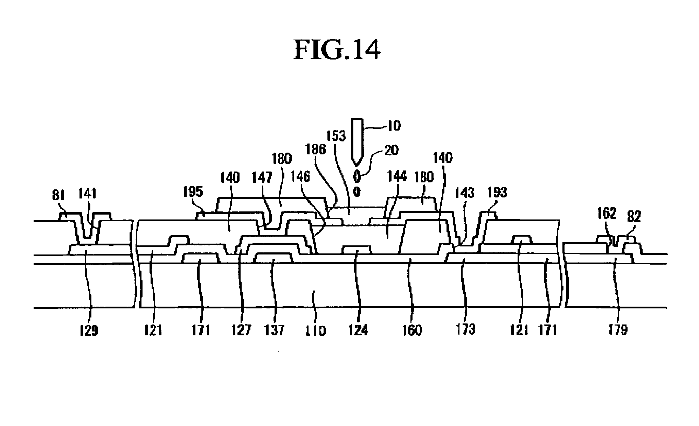

Next, as shown in Fig. 14, an ink-jet head (not shown) including a nozzle 10 is aligned on the organic semiconductor islands 153 and sprays a solvent 20. As long as the solvent 20 may melt the organic semiconductor islands 153, the solvent 20 is not restricted. It is preferable that the solvent 20 is the above-described material, and more particularly the solvent 20 is the same as the solvent of the organic semiconductor solution.

By spraying the solvent 20, the solid organic semiconductor islands 153 are re-melted into an organic semiconductor solution. Here, the solvent 20 disperses the cohered organic semiconductor with a wide area in the openings 186.

Next, the organic semiconductor solution is dried at room temperature and the annealing process is slowly executed to remove the solvent 20 for 10 to 30 minutes in the temperature of 70 to 130 degrees Celsius, thus forming the organic semiconductor islands 154. The organic semiconductor molecules of the organic semiconductor islands 154 are reoriented by the re-melting and drying steps, and the resultant organic semiconductor islands 154 have different characteristics in comparison with the organic semiconductor islands 153 before re-melting,

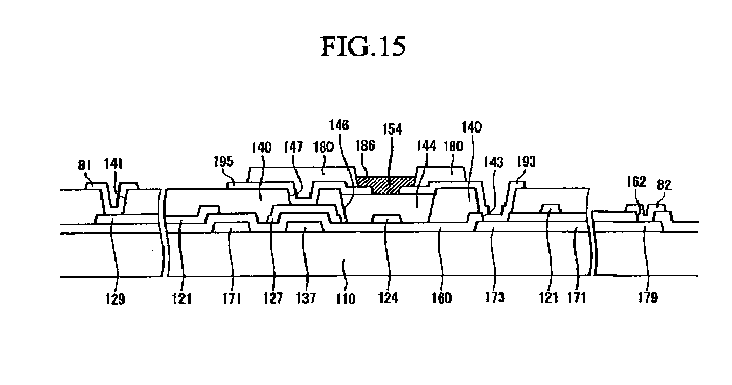

In Fig. 15, the slashed portions indicate the organic semiconductor islands 154.

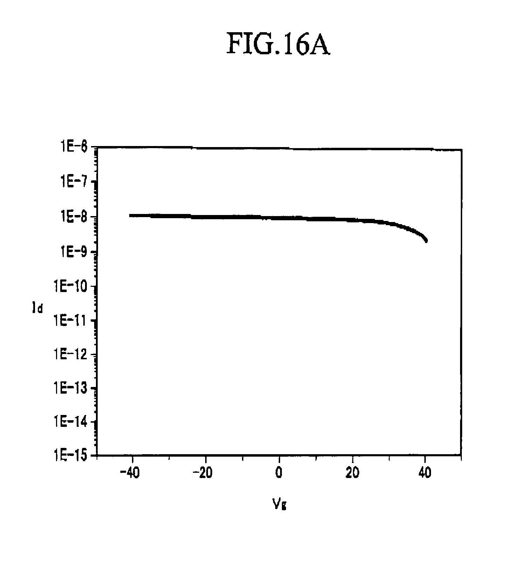

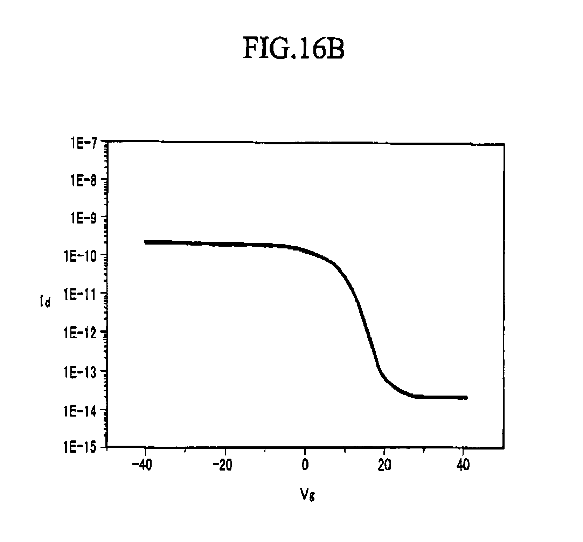

The organic semiconductor molecules of the organic semiconductor islands 153 prior to the re-melting and drying process are randomly aligned with irregular directions, but the organic semiconductor molecules of the re-melted organic semiconductor islands 154 are reoriented and dispersed such that the arrangement of the organic semiconductor molecules of the organic semiconductor islands 154 may be changed due to the change of arrangement angle of the cyclic compound. Accordingly, the OTFT of the organic semiconductor islands 154 have different characteristics in comparison with the organic semiconductor islands 153, as will be described with reference to Figs. 16A and 16B.

Fig. 16A is a graph showing the current characteristics of an exemplary OTFT before re-melting an exemplary organic semiconductor, and Fig. 16B is a graph showing the current characteristics of an exemplary OTFT after re-melting an exemplary organic semiconductor.

As shown in Fig. 16A, though the gate voltage Vg is changed, the drain current Id of the OTFT before re-melting an organic semiconductor is almost never changed, and accordingly the ratio Ion/Ioff of the OTFT is low. However, as shown in Fig. 16B, when re-melting the organic semiconductor according to the embodiment of the present invention, the on current Ion of the OTFT is high and the off current Ioff of the OTFT is rapidly decreased, such that the ratio Ion/Ioff of the OTFT is increased.

As a result, the organic semiconductors that are cohered in the narrow area are dispersed in the wide area by re-melting and drying steps, and the arrangement of the organic semiconductor molecules of the organic semiconductor islands 154 are reoriented such that the leakage current is decreased and the current characteristic of the OTFT is improved.

Next, as shown in Figs. 1 and 2, a plurality of passivation members 186 for covering the organic semiconductor islands 154 are formed on the organic semiconductor islands 154 within the openings 186 by ink-jet printing.

According to the exemplary embodiments of the present invention, because the organic semiconductor molecules of the organic semiconductors are reoriented by re-melting and drying steps, the current characteristic of the OTFT may be improved.

Although preferred and exemplary embodiments of the present invention have been described in detail hereinabove, it should be clearly understood that many variations and/or modifications of the basic inventive concepts herein taught which may appear to those skilled in the present art will still fall within the spirit and scope of the present invention, as defined in the appended claims.

## Claims

1. A method of manufacturing a thin film transistor array panel, the method comprising:
forming a gate electrode;
forming source and drain electrodes insulated from the gate electrode;
forming an organic semiconductor contacting the source and drain electrodes;
spraying a solvent on the organic semiconductor;
drying the solvent; and
annealing the organic semiconductor.

2. The method of claim 1, wherein drying the solvent is is executed at room temperature.

3. The method of claim 1, wherein the solvent includes at least one of tetralin, cyclohexane, benzene, xylene, anisole, benzonitrile, lutidine, morpholine, aniline, toluene, pyridine, dioxane, and derivatives thereof.

4. The method of claim 3, wherein forming the organic semiconductor contacting the source and drain electrodes includes forming the organic semiconductor by a solution process using an organic semiconductor solution including a organic material and a solvent

5. The method of claim 4, wherein the solution process is ink-jet printing.

6. The method of claim 5, wherein the solvent used in spraying a solvent on the organic semiconductor is me same as the solvent within the organic semiconductor solution.

7. The method of claim 1, wherein annealing the organic semiconductor is executed at a temperature of about 70 to 130 degrees Celsius.

8. The method of claim 1, further comprising
forming a gate insulator on the gate electrode,
wherein the gate insulator is formed by ink-jet printing.

9. The method of claim 8, further comprising
forming a partition defining an opening for the organic semiconductor on the gate insulator.

10. A method of manufacturing a thin film transistor array panel, the method comprising:
forming a gate electrode;
forming source and drain electrodes insulated from the gate electrode; and
forming an organic semiconductor contacting the source and drain electrodes,
wherein forming the organic semiconductor includes
spraying an organic semiconductor solution,
first-drying the organic semiconductor solution,
re-metting the organic semiconductor solution to form re-melted organic semiconductor solution, and
second-drying the re-melted organic semiconductor solution.

11. The method of claim 10, wherein re-melting the organic semiconductor solution includes spraying a solvent on the organic semiconductor solution.

12. The method of claim 11, wherein the solvent includes at least one of tetralin, cyclohexane, benzene, xylene, anisole, benzonitrile, lutidine, morpholine, aniline, toluene, pyridine, dioxane, and derivatives thereof.

13. The method of claim 11, wherein the organic semiconductor solution includes a solvent and an organic material, and the solvent used in spraying is the same as the solvent of the organic semiconductor solution.

14. The method of claim 11, wherein second-drying the re-melted organic semiconductor solution includes drying at room temperature and annealing the organic semiconductor solution.

15. The method of claim 14, wherein annealing the organic semiconductor solution is executed at a temperature of about 70 to 130 degrees Gelsius,

16. A method of a thin film transistor having an organic semiconductor, the method comprising:
forming a gate electrode;
forming source and drain electrodes insulated from the gate electrode;
providing an organic semiconductor solution including an organic material and a first solvent for the thin film transistor and contacting the source and drain electrodes;
first-drying the organic semiconductor solution to form an organic semiconductor having a first arrangement of organic semiconductor molecules;
melting and second-drying the organic semiconductor to form an organic semiconductor having a second arrangement of organic semiconductor molecules.

17. The method of claim 16, wherein a ratio of on-current to off-current of the thin film transistor having the second arrangement of organic semiconductor molecules is greater than a ratio of on-current to off-current of a thin film transistor having the first arrangement of organic semiconductor molecules.

18. The method of claim 16, wherein melting the organic semiconductor to form an organic semiconductor having a second arrangement of organic semiconductor molecules includes applying a second solvent.

19. The method of claim 18, wherein the second solvent is the same solvent as the first solvent

20. The method of claim 18, wherein applying the second solvent includes spraying the second solvent with an ink-jet nozzle.

21. The method of claim 16, wherein second-drying the organic semiconductor to form an organic semiconductor having a second arrangement of organic semiconductor molecules includes drying at room temperature and performing an annealing process.

22. The method of claim 16, wherein the second arrangement is different than the first arrangement of organic semiconductor molecules, and
wherein characteristics of a thin film transistor having an organic semiconductor with the second arrangement of organic semiconductor molecules are different than characteristics of a thin film transistor having an organic semiconductor with the first arrangement of organic semiconductor molecules.
